# EUROPEAN PATENT APPLICATION

(11) **EP 4 653 904 A1**
(43) Date of publication of application: **26.11.2025**
(21) Application number: 24177080.9
(22) Date of filing: 21.05.2024
(51) Int. Cl.: G01R 33/56, G01R 33/561, G01R 33/565, G01R 33/50

(54) **REMOVAL OF FREE INDUCTION DECAY ARTIFACTS IN TURBO SPIN ECHO MRI IMAGES**

(71) Applicant: Koninklijke Philips N.V., 5656 AG Eindhoven (NL)
(72) Inventor: NIELSEN, Tim, Eindhoven (NL)
(74) Representative: Philips Intellectual Property & Standards

(57) **Abstract**

Disclosed herein is a method of imaging at least a part of a subject (318). The method comprises receiving (200) k-space data (122) acquired according to a fast spin echo magnetic resonance imaging protocol. The method further comprises reconstructing (202) an initial magnetic resonance image (124) from the k-space data. The method further comprises receiving (204) a free induction decay artifact image (128) in response to inputting the initial magnetic resonance image into an image processing neural network (126). The image processing neural network is configured for filtering free induction decay artifacts from fast spin echo magnetic resonance images. The method further comprises generating (206) a clinical magnetic resonance image (130), through a combination of at least a portion of the free induction decay artifact image and the initial magnetic resonance image. The method further comprises providing (208) the clinical magnetic resonance image.

## Description

### TECHNICAL FIELD

The invention relates to magnetic resonance imaging, in particular to improvement of quality of magnetic resonance images.

### BACKGROUND

A large static magnetic field is used by Magnetic Resonance Imaging (MRI) scanners to align the nuclear spins of atoms as part of the procedure for producing images within the body of a subject. This large static magnetic field is referred to as the B0 field or the main magnetic field. In MRI, the atomic spins are manipulated using gradient magnetic fields and radiofrequency (RF) pulses.

Various magnetic resonance imaging protocols may be used. In conventional spin echo imaging, an RF pulse is first used to produce a free induction decay and then a (typically 180 degree) refocusing pulse is used to rephase spins to cause a so called "spin echo" RF signal from the spins. A Turbo Spin Echo (TSE) pulse sequence (also known as a fast spin echo) is similar to the spin echo pulse sequence except that refocusing pulses are repeatedly used. A common problem with TSE imaging is that the rephasing of the spins by the subsequent refocusing pulses is typically not perfect. The refocusing pulse may cause a new free induction decay from some of the spins. Instead of generating a pure spin echo signal the spins generate a signal that is a combination of the new free induction decay and the spin echo signal. The new free induction decay can lead to image artifacts.

### SUMMARY

The invention provides a method of imaging at least part of a subject, a method of training a neural network, a medical system, and a computer program product in the independent claims. Embodiments are given in the dependent claims.

In one aspect a method of imaging at least part of a subject is disclosed. The method comprises receiving k-space data acquired according to a turbo spin echo magnetic resonance imaging protocol. The k-space data is descriptive of the part of the subject. The method further comprises reconstructing an initial magnetic resonance image from the k-space data. The method further comprises receiving a free induction decay artifact image in response to inputting the initial magnetic resonance image into an image processing neural network. The image processing neural network is configured for filtering free induction decay artifacts from turbo spin echo magnetic resonance images. The method further comprises generating a clinical magnetic resonance image. The generation of the clinical magnetic resonance image comprises combining at least a portion of the free induction decay artifact image and the initial magnetic resonance image. The method further comprises providing the clinical magnetic resonance image.

In another aspect, a method of training an image processing neural network is disclosed. The training method comprises receiving training data comprising pairs of training input images and free induction decay artifact output images. The training input images are combinations of a free induction decay artifact-free magnetic resonance images and the corresponding free induction decay artifact output images. The training method further comprises training the image processing neural network using the training data by inputting the training input images into the image processing neural network and using the corresponding free induction decay artifact output images as target images.

In another aspect a medical system for internally imaging at least a part of the subject is disclosed. It comprises a computational system configured to perform a method of imaging at least a part of the subject.

In another aspect a computer program product comprising machine-executable instructions is disclosed. Execution of the machine-executable instructions causes the computational system to perform a method of imaging at least a part of the subject or the method of training the image processing neural network.

Features described above with respect to method embodiments are applicable and are contemplated also for corresponding system embodiments, with similar benefits.

This Summary is provided to introduce a selection of concepts in a simplified form that are further described below in the Detailed Description. This Summary is not intended to identify key features or essential features of the claimed subject matter, nor is it intended to limit the scope of the claimed subject matter. A more extensive presentation of features, details, utilities, and advantages of the system embodiment and method embodiments, as defined in the claims, is provided in the following written description of various embodiments of the disclosure and illustrated in the accompanying drawings.

### BRIEF DESCRIPTION OF THE DRAWINGS

In the following preferred embodiments of the invention will be described, by way of example only, and with reference to the drawings in which:
Fig. 1 illustrates an example of a medical system.
Fig. 2 shows a flow chart which illustrates a method of using the medical system of Fig. 1.
Fig. 3 illustrates a further example of a medical system.
Fig. 4 shows a flow chart which illustrates a method of using the medical system of Fig. 3.
Fig. 5 illustrates an example of a computer system used for training an image processing neural network.
Fig. 6 shows a flow chart which illustrates a method of training an image processing neural network using the computer system of Fig. 5.
Fig. 7 illustrates an example of a medical system that comprises a cloud-based computing system.
Fig. 8 shows the decomposition of k-space data that comprises spin echo k-space data and free induction decay artifact k-space data.
Fig. 9 illustrates a clinical magnetic resonance image generated from an initial magnetic resonance image and a free induction decay artifact image.

### DESCRIPTION OF EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alteration and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer implemented method and/or in a computer program product, in a corresponding manner.

Like numbered elements in these figures are either equivalent elements or perform the same function. Elements which have been discussed previously will not necessarily be discussed in later figures if the function is equivalent.

In an example there is a method of imaging at least a portion of a subject. The portion may refer to a part of the body of the subject. The imaging may be performed using magnetic resonance imaging and the part of the subject may for example be located within an imaging zone of a magnetic resonance imaging system. The method comprises receiving k-space data acquired according to a turbo spin echo (TSE) magnetic resonance imaging protocol, also known as fast spin echo (FSE) imaging protocol or imaging sequence. The k-space data is descriptive of the part of the subject. The method further comprises reconstructing an initial magnetic resonance image from the k-space data.

In turbo spin echo magnetic resonance imaging there are a series of refocusing RF pulses that are used to rephase the magnetic resonance imaging system to allow the acquisition of the k-space data. In theory, 180° refocusing pulses would enable the production of a train of echoes that just comprises the k-space data which is intended to be measured. However, in practice, the refocusing pulses typically have an angle which is less than 180°. This is particularly true in three-dimensional turbo spin echo procedures because the reduction in the angle of the refocusing pulse can be useful in reducing absorption of RF energy by the body. A consequence of having refocusing pulses that are less than 180° is that for each refocusing pulse a free induction decay signal is also generated. In this case the k-space data comprises data due to the echo train after the refocusing pulses as well as the free induction decay signals. These free induction decay signals may for example cause interference fringes in the reconstructed magnetic resonance image. The initial magnetic resonance image may therefore comprise the k-space data descriptive of the intended image plus a free induction decay artifact superimposed or added to it.

The method further comprises receiving a free induction decay artifact image in response to inputting the initial magnetic resonance image into an image processing neural network. The image processing neural network is configured for filtering free induction decay artifacts from turbo spin echo magnetic resonance images. The image processing neural network receives as input the initial magnetic resonance image and then outputs the free induction decay artifact image. The method further comprises generating a clinical magnetic resonance image. The generating comprises a combination of at least a portion of the free induction decay artifact image and the initial magnetic resonance image.

Typically, the free induction decay artifact image will be subtracted from the initial magnetic resonance image. The result of this subtraction is a clinical magnetic resonance image, which has the free induction decay artifact removed or reduced. Often it is beneficial to take the initial magnetic resonance image and then subtract the free induction decay artifact image from it. Sometimes, in other embodiments, when removing a noise artifact from an image it is beneficial to remove only part of the image, so the free induction decay could be multiplied by a scalar value before subtracting it from the initial magnetic resonance image. This may for example result in a clinical magnetic resonance image, which is perceived as having a higher quality than if the entire free induction decay artifact image is removed. The method further comprises providing the clinical magnetic resonance image. This may for example be storing it within a medical image database or presenting it or displaying it on a display for examination by a radiologist or other medical professional.

This example may be beneficial because it may provide for a straightforward means of removing the free induction decay artifact image from a turbo spin echo magnetic resonance image and provide a clinical magnetic resonance image with higher image quality.

As used herein, an "initial magnetic resonance image" and a "clinical magnetic resonance image" are both magnetic resonance images. The terms "initial" and "clinical" are labels intended to differentiate the two images, which with other words may be termed as first magnetic resonance image and second magnetic resonance image. The "initial" magnetic resonance image is used to identify the magnetic resonance image input into the image processing neural network. The "clinical" magnetic resonance image is a magnetic resonance image constructed from the combination of the free induction decay artifact image and the "initial" magnetic resonance image. The "clinical" magnetic resonance image, may for example, be constructed by subtracting some factor of the free induction decay artifact image from the initial magnetic resonance image.

In another example the method further comprises acquiring the k-space data by controlling a magnetic resonance imaging system with pulse sequence commands. The pulse sequence commands are according to the turbo spin echo magnetic resonance imaging protocol. As was mentioned above, this method may be beneficial because it may provide clinical magnetic resonance images with superior image quality and a reduction in the free induction decay artifacts.

In another example, the turbo spin echo magnetic resonance imaging protocol is a three-dimensional turbo spin echo magnetic resonance imaging protocol. This example is particularly beneficial because in turbo spin echo magnetic resonance imaging protocols it is desirable to reduce the specific absorption rate (SAR) or specific absorption limitations. The SAR is a measure of how much energy is deposited into the subject. In turbo spin echo magnetic resonance imaging protocols the SAR can be reduced by reducing the angle of the refocusing pulses. By using a refocusing pulse with less than 180° the SAR can be reduced resulting in a safer and more comfortable procedure for the subject. This however has the disadvantage that the free induction decay artifacts will be increased. The use of the image processing neural network to generate the free induction decay artifact image provides a means of providing the clinical magnetic resonance image with a superior image quality although a refocusing pulse of less than 180° is used.

In another example, the pulse sequence commands are configured to cause the magnetic resonance imaging system to acquire the k-space data using refocusing pulses with flip angles less than 180°. The flip angles are preferably less than 160° and the flip angles may in some embodiments be more preferably less than 140°. As the flip angle is reduced, the SAR, as was mentioned above, is reduced. With the decreasing flip angle the strength of the free induction decay artifact increases. Methods may therefore provide for superior quality of the clinical magnetic resonance image while at the same time allow the use of a lower flip angle which also increases the safety and comfort of the subject.

In another example, the clinical magnetic resonance image is any one of the following: a brain image, a knee image, a muscular skeletal image, a spine image, a lumber spine image, and a brain vessel wall image. Each of these image types are often acquired in clinical practice using turbo spin echo magnetic resonance imaging protocols. For these particular applications the method may be particularly beneficial as it would enable higher quality clinical magnetic resonance images to be produced.

In another example, the image processing neural network is any one of the following: a feed-forward convolutional neural network, a bias-free feed-forward convolutional neural network with skip connections, a DnCNN, a U-Net, a ResNet, a DenseNet, and an auto-encoder neural network. The use of any of these neural network architectures may be beneficial because they have the capacity to remove image artifacts from images.

In another example, the convolutional neural network is trained according to a method of training a neural network as disclosed herein.

In another aspect, a method of training an image processing neural network is disclosed. The training method comprises receiving training data comprising pairs of training input images and free induction decay artifact output images. The training input images are combinations of a free induction decay artifact-free magnetic resonance images and corresponding free induction decay artifact output images. For each free induction decay artifact-free magnetic resonance image there is a corresponding free induction decay artifact output image.

The training method further comprises training the image processing neural network using the training data by inputting the training input images into the image processing neural network and using the corresponding free induction decay artifact output images as target images. For example, the training may be used according to a deep learning training protocol for the image processing neural network. The image processing neural network may be trained using individual pairs or they may be done in batches. This example may be beneficial because it provides for an image processing neural network that is able to generate a free induction decay artifact image when an initial magnetic resonance image that contains a free induction decay artifact is input into it.

In another example, the training method further comprises receiving training datasets of data comprising a T1 map, a T2 map, and a proton density map. The method further comprises generating the pairs of training input images and the free induction decay output images synthetically using the sets of data comprising the T1 map, the T2 map, and the proton density map. This may be particularly beneficial because with a knowledge of the T1 map, the T2 map, and the proton density map one is able to produce synthetic magnetic resonance images according to any desired magnetic resonance imaging protocol. Images both with and without the free induction decay artifact can therefore be produced.

There may be different sources of obtaining a T1 map, a T2 map and a proton density map for particular clinical situations. One particular means of doing this is to obtain a magnetic resonance fingerprint. In magnetic resonance imaging fingerprinting a pulse sequence which varies the time and pulse sequence parameters is compared against a magnetic resonance imaging fingerprinting dictionary to determine various physical quantities on a voxel-by-voxel basis. The use of magnetic resonance fingerprinting may provide very accurate measurement of the T1 value, the T2 value, and the proton density for particular clinical measurements. This data obtained from the magnetic resonance fingerprinting can then be used to generate a T1 map, a T2 map, and a proton density map that can be used for generating one pair of the training data.

In another example, the training method further comprises receiving for the training data the free induction decay artifact-free magnetic resonance images. These images do not have the free induction decay artifact. They may for example be obtained using a protocol which reduces the artifacts such as using a 180° refocusing pulse. The training method further comprises providing image-specific segmentations by segmenting the free induction decay artifact-free magnetic resonance images. The images may also be acquired using completely different magnetic resonance imaging sequences that do not produce free induction decay artifacts. The purpose of the images is to provide realistic anatomical structures as a basis for the simulation of the training images.

There may for example be various image segmentation algorithms which can be used, for example, a shape deformable body model or fitting the images to an anatomical atlas. The training method further comprises assigning the image-specific segmentations with T1 relaxation times, a T2 relaxation time and the proton density values. If the image has been segmented, then it may be known which portions of the image correspond to which types of tissue of a subject. A knowledge of the typical T1 relaxation times, T2 relaxation times, and proton density within these known regions can be used to provide an accurate estimate. The method then comprises for the free induction decay artifact-free magnetic resonance images synthetically generating the corresponding target free induction decay artifact images using the corresponding T1 relaxation times, the T2 relaxation times, and the proton density values for the specific image segmentations. The regions of the subject which result in the largest artifact are typically the regions with a short T1 relaxation time. However, it is not necessary to picture these regions, as the regions with a larger or longer T1 relaxation time contribute less to this artifact image. The method further comprises providing the input training images by combining the corresponding target free induction decay artifact images to the corresponding free induction decay artifact-free magnetic resonance images. This may for example be accomplished by adding a synthetic image with the artifact to the corresponding free induction decay artifact-free magnetic resonance image. This example may be beneficial because it may provide for very accurate training of the image processing neural network.

In another example, the generation of the synthetic training input images and/or the target free induction decay images is performed using the extended phase graph method or a solution of a Bloch equation. The Bloch equation can be used to simulate the magnetic resonance signals and therefore produce accurate synthetic magnetic resonance images. The extended phase graph method is an approximation, which provides for a means of also producing accurate synthetic magnetic resonance images without the full solution of the Bloch equation.

In another example, there is a medical system for internally imaging at least a part of the subject. The medical system comprises a computational system configured for performing a method as disclosed above.

In another example, the medical system further comprises a magnetic resonance imaging system configured for being controlled by the computational system to acquire the k-space data acquired according to the turbo spin echo magnetic resonance imaging protocol. The medical system further comprises a display screen configured for being controlled by the computational system to display the clinical magnetic resonance image. In another example, there is a computer program product comprising the machine-executable instructions. Execution of the machine-executable instructions causes a computational system to perform a method as disclosed above.

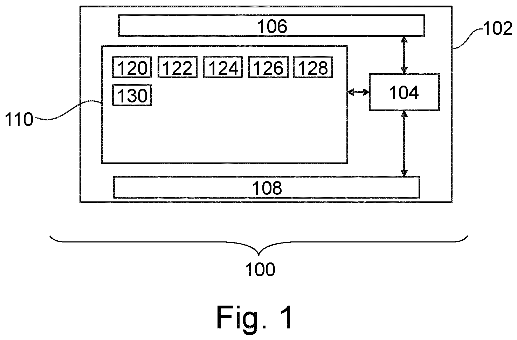

Fig. 1 illustrates an example of a medical system 100. The medical system is shown as comprising a computer 102. The computer 102 may represent various types of computers and computer systems. For example, the computer 102 could be part of a system controlling a magnetic resonance imaging system, could be an external blade or virtual computing system, a workstation for use by a radiologist or other medical professional, or a common computer system. The computer 102 is shown as comprising a computational system 104.

The computational system 104 could represent various computing cores or computational systems that are located at one or more locations. For example, the computer 102 or the computational system 104 could be implemented in a distributed or cloud-based system. The computational system 104 is shown as being in communication with an optional hardware interface 106 and an optional user interface 108. The user interface 108 may for example be used by an operator to control the operation and functioning of the system 100 either locally or remotely. The user interface may comprise any of input and/or output peripherals, for example a display screen. The hardware interface 106, if it is present, may for example be used to control other components of the medical system 100 such as a magnetic resonance imaging system. The optional user interface 108 may serve for example to control operating and controlling the medical system 100 as well as for example to display magnetic resonance images.

The computational system 104 is further shown as being in communication with a memory 110. The memory 110 is intended to represent various types of memory which are accessible to the computational system 104. The memory 110 is shown as containing machine-executable instructions 120. The machine-executable instructions 120 contain instructions, which enable the computational system 104 to perform such tasks as controlling other components, performing image processing tasks, and performing numerical computational tasks. The memory 110 is further shown as containing k-space data 122. The k-space data 122 may for example be stored in the memory 110 or may be received via a network connection. In other examples the medical system 100 may further comprise a magnetic resonance imaging system, which was used to acquire the k-space data 122. The k-space data 122 is acquired according to a TSE or FSE magnetic resonance imaging protocol. The memory 110 is further shown as containing an initial magnetic resonance image 124.

As the k-space data 122 was acquired with a turbo spin echo magnetic resonance imaging protocol it will likely contain free induction decay artifacts. The memory 110 is further shown as containing an image processing neural network 126. The memory 110 is further shown as containing a free induction decay artifact image 128 that was received from the image processing neural network 126 in response to inputting the initial magnetic resonance image 124. The image processing neural network 126 is therefore trained to extract the free induction decay artifact image 128 from the initial magnetic resonance image 124. The memory 110 is further shown as containing a clinical magnetic resonance image 130 that was constructed by subtracting at least a portion of the free induction decay artifact image 128 from the initial magnetic resonance image 124.

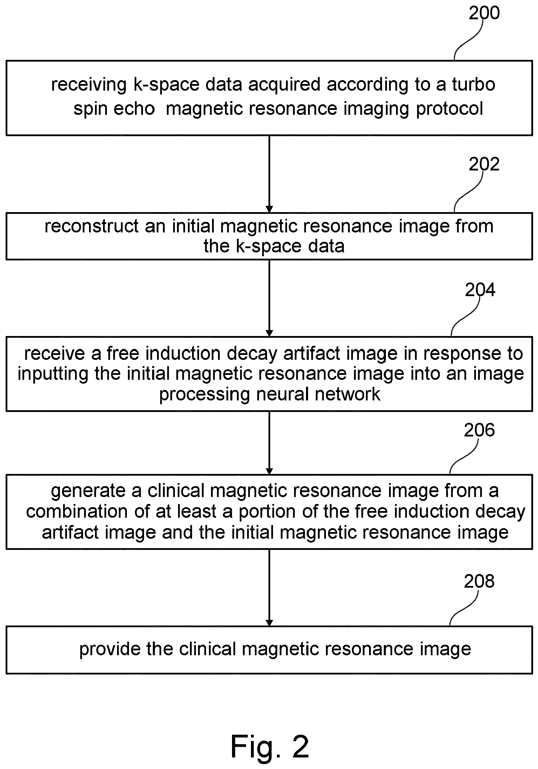

Fig. 2 shows a flowchart, which illustrates a method of operating a medical system, for example schematically depicted in Fig. 1. In step 200, the k-space data 122 is received. The k-space data 122, as was mentioned above, was acquired according to a turbo spin echo magnetic resonance imaging protocol. The k-space data is descriptive of at least a part of a subject. In step 202, the initial magnetic resonance image 124 is reconstructed from the k-space data 122. In step 204, the free induction decay artifact image is received in response to inputting the initial magnetic resonance image 124 into the image processing neural network 126. In step 206, the clinical magnetic resonance image 130 is generated from a combination of at least a portion of the free induction decay artifact image 128 and the initial magnetic resonance image 124. In some embodiments, the free induction decay artifact image 128 will be multiplied by a scalar value and then subtracted from the initial magnetic resonance image 124. In step 208, the clinical magnetic resonance image 130 is provided. This may for example be a storage of the image in the memory 110 or other storage medium or for example, displaying it using the optional user interface or display 108.

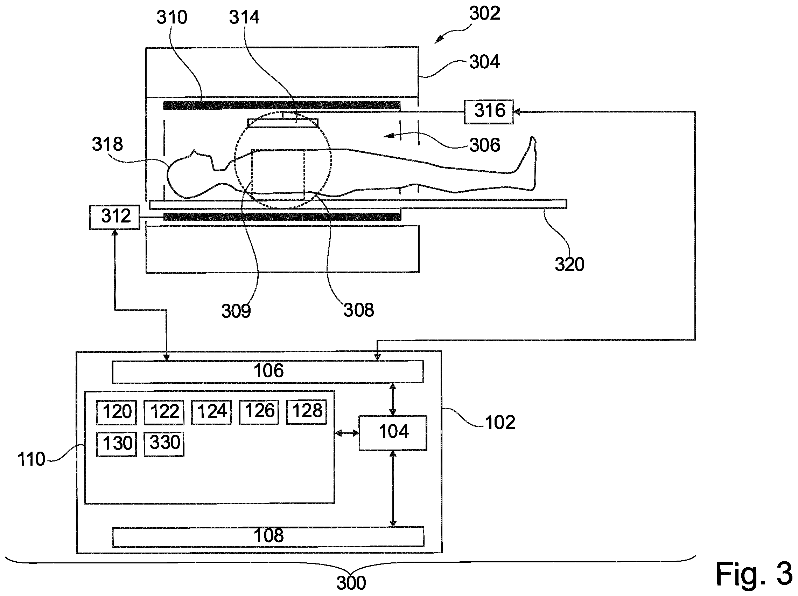

Fig. 3 illustrates a further example of a medical system 300 that further comprises a magnetic resonance imaging system 302 or with other words the MRI scanner. The magnetic resonance imaging system 302 comprises a magnet 304. The magnet 304 may be a superconducting cylindrical type magnet with a bore 306 through it. It is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject. The arrangement of the two sections area is similar to that of a Helmholtz coil. Open magnets are popular because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A field of view 309 is shown within the imaging zone 308. The k-space data are acquired for the field of view 309. The region of interest could be identical with the field of view 309 or it could be a sub-volume of the field of view 309. A subject 318 is shown as being supported by a subject support 320 such that at least a portion of the subject 318 is within the imaging zone 308 and the field of view 309.

Within the bore 306 of the magnet there is also a set of magnetic field gradient coils 310, which is used for the acquisition of measured k-space data to spatially encode magnetic spins within the imaging zone 308 of the magnet 304. The magnetic field gradient coils 310 are connected to a magnetic field gradient coil power supply 312. The magnetic field gradient coils 310 are intended to be representative. Typically, magnetic field gradient coils 310 contain three separate sets of coils for spatial encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 is a radiofrequency coil 314 for manipulating the orientations of magnetic spins within the imaging zone 308 and for receiving radio transmissions from spins also within the imaging zone 308. The radiofrequency antenna may contain multiple coil elements. The radiofrequency antenna may also be referred to as a channel or antenna. The radiofrequency coil 314 is connected to a radiofrequency transceiver 316. The radiofrequency coil 314 and radiofrequency transceiver 316 may be replaced by separate transmit and receive coils and a separate transmitter and receiver. It is understood that the radiofrequency coil 314 and the radiofrequency transceiver 316 are representative. The radiofrequency coil 314 is intended to also represent a dedicated transmit antenna and a dedicated receive antenna. Likewise, the transceiver 316 may also represent a separate transmitter and receiver. The radiofrequency coil 314 may also have multiple receive/transmit elements and the radiofrequency transceiver 316 may have multiple receive/transmit channels. The transceiver 316 and the gradient controller 312 are shown as being connected to the hardware interface 106 of the computer system 102.

The magnetic resonance imaging system 302 is shown as being controlled by the computer system 102. The memory 110 is further shown as containing pulse sequence commands 330. The pulse sequence commands may be commands or data which may be converted into commands, which are used to control the magnetic resonance imaging system 302 to acquire the k-space data 122. In this case the pulse sequence commands 330 are configured such that they acquire the k-space data 122 according to a turbo spin echo magnetic resonance imaging protocol.

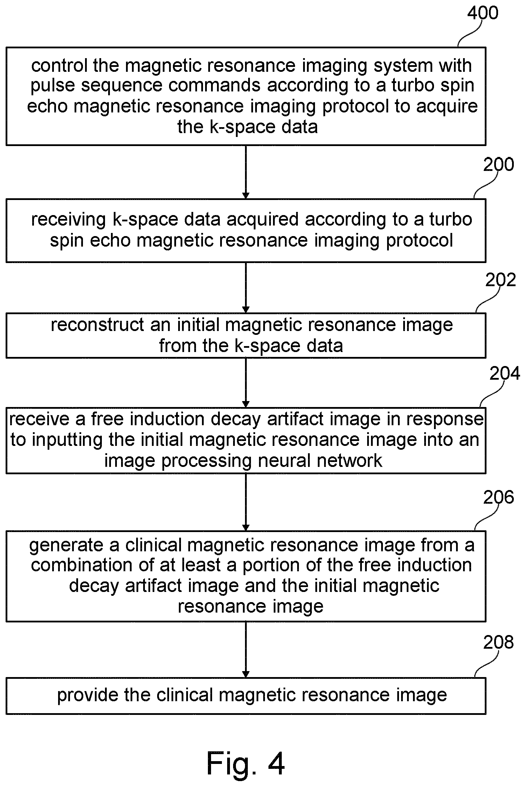

Fig. 4 shows a flowchart, which illustrates a method of controlling the medical system 300. In step 400, the magnetic resonance imaging system 302 is controlled with the pulse sequence commands 330 to cause the magnetic resonance imaging system 302 to acquire the k-space data 122 according to a turbo spin echo magnetic resonance imaging protocol. Steps 200, 202, 204, 206, and 208 are performed as was illustrated in Fig. 2.

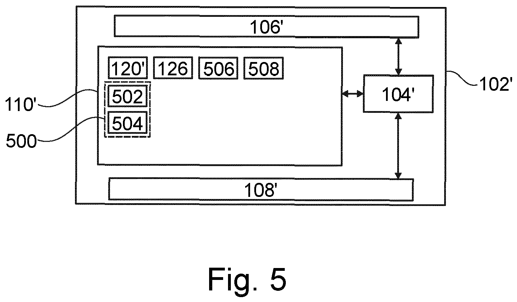

Fig. 5 illustrates a further example of a computer 102'. The computer 102' could be a separate computer from computer 102 or it could also have its functionality integrated into the computer 102 illustrated in Figs. 1 and 3. Likewise, the computer 102' is further shown as containing an optional hardware interface 106', an optional user interface 108', and a memory 110'.

The memory 110' is shown as comprising machine-executable instructions 120'. The machine-executable instructions 120' could be incorporated into the machine-executable instructions 120 or they could be separate. The memory 110' is shown as containing a copy of the image processing neural network 126 which will be trained initially or will be further trained. The memory 110' is further shown as containing training data 500 that comprises matching pairs of training input images 502 and free induction decay artifact output images 504. The training input images 502 are used as input to the image processing neural network 126 and then this output is then compared against the corresponding free induction decay artifact output images 504, which is used as target data. A deep learning training algorithm could for example be implemented in the machine-executable instructions 120' and this would then be used to train or further train the image processing neural network 126.

The memory 110' is shown as further optionally containing sets of T1 relaxation maps, T2 relaxation maps, and proton density maps. Each set could for example have been obtained using a magnetic resonance imaging fingerprint acquisition. The memory 110' is further shown as containing an extended phase graph solver 508. The extended phase graph solver 508 may take one set of the T1 relaxation map, T2 relaxation map, and proton density map and then use this to generate one training pair.

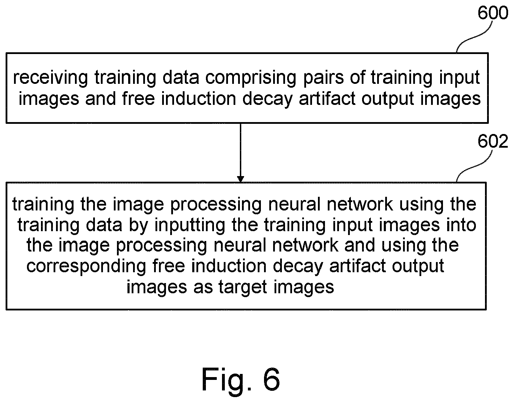

Fig. 6 shows a flowchart, which illustrates a method of operating the computer system 102' of Fig. 5. In step 600 the training data 500 is received. The training data 500 comprises pairs of training input images 502 and free induction decay artifact output images 504. In step 602, the image processing neural network 126 is trained using the training data 500. The training input images 502 are used as input into the image processing neural network 126 and its output is compared to the corresponding free induction decay artifact output image 504. For example, a deep learning algorithm can be used to train the image processing neural network 126 with the training data 500.

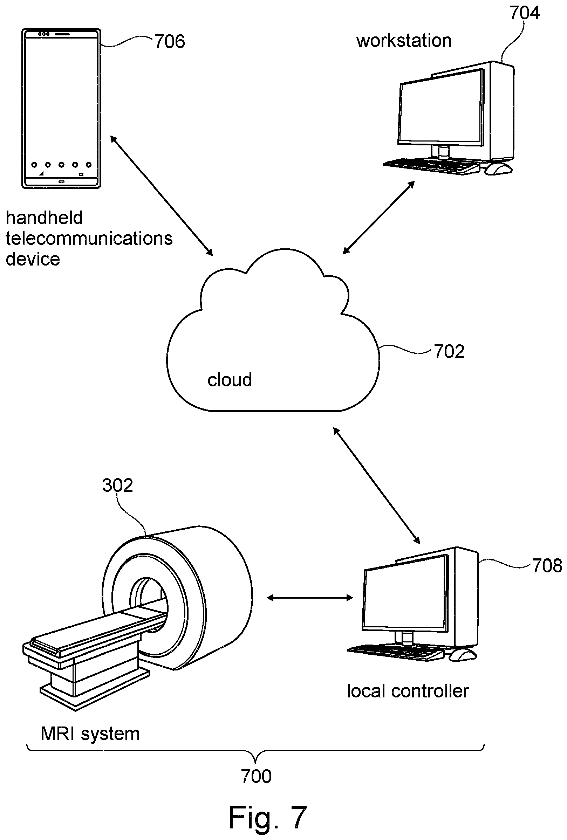

Fig. 7 illustrates a further example of a medical system 700. The medical system 700 may comprise the magnetic resonance imaging system 302 as well as a cloud-based computing system 702, a radiology workstation 704, a handheld telecommunications device 706, and a local controller 708. The functionality of the computer 102 in Figs. 1 and 3 and computer 102' in Fig. 5 can be distributed amongst the various devices 702, 704, 706, and 708. The cloud-based computing system 702 could be formed of networked servers and/or virtual machines available over the internet or other network.

A typical configuration would be to use the local controller 708 to use the pulse sequence commands 330 to control the magnetic resonance imaging system 302 to acquire the k-space data. The reconstruction of the initial magnetic resonance image as well as the clinical magnetic resonance image may be performed by the cloud-based computing system 702. The resulting clinical magnetic resonance image would then be made available to the workstation 704, the handheld telecommunications device 706, and the local controller 708. The cloud-based computing system may, in some examples, also be used to provide the training of the image processing neural network 126 as illustrated in Figs. 5 and 6.

As it was mentioned hereinbefore, each refocusing pulse of a TSE sequence may also create transverse magnetization, which produces the free induction decay (FID) signal. This is especially relevant for three dimensional TSE, where the flip angle of the refocusing pulse is often much less than 180° due to long TSE shots and SAR limitations. In these cases, the signal intensity of the FID may be stronger than the spin echo.

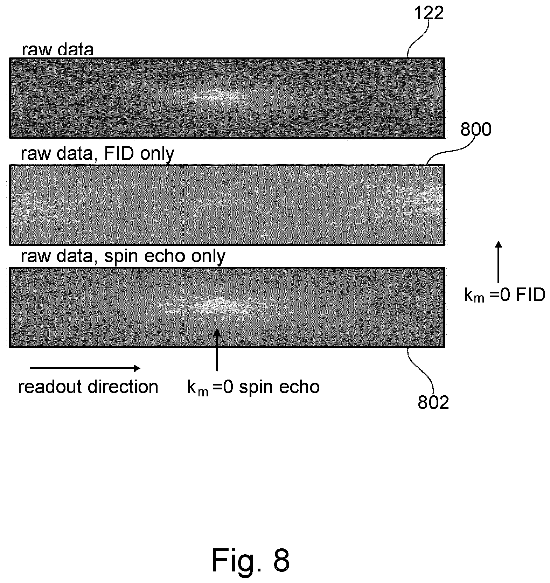

The readout is centered around the echo time of the spin echo but also picks up the outer edges of the k-space of the FID at the beginning and the end of the acquisition window. Thus, in k-space, the spin echo and the FID are well separated. This is illustrated in Fig. 8.

The amplitude of the FID signal at different locations of the imaged object depend on the radiofrequency filed (B1), the proton density, T1 and T2 values. They can be computed for a given sequence by the extended phase-graph (EPG) formalism. Heuristically, it shows mainly components with short T1 (e.g., fat).

Fig. 8 shows an image, which illustrates the raw k-space data 122 acquired from a single channel. The k-space data 122 contains k-space data from the spin echo measurements as well as data caused by the free induction decay. This data has been split into two components. Image 800 shows the raw data containing only data which represents the free induction decay artifact. The image 802 shows the raw k-space data for the same channel, but only the data from the spin echo.

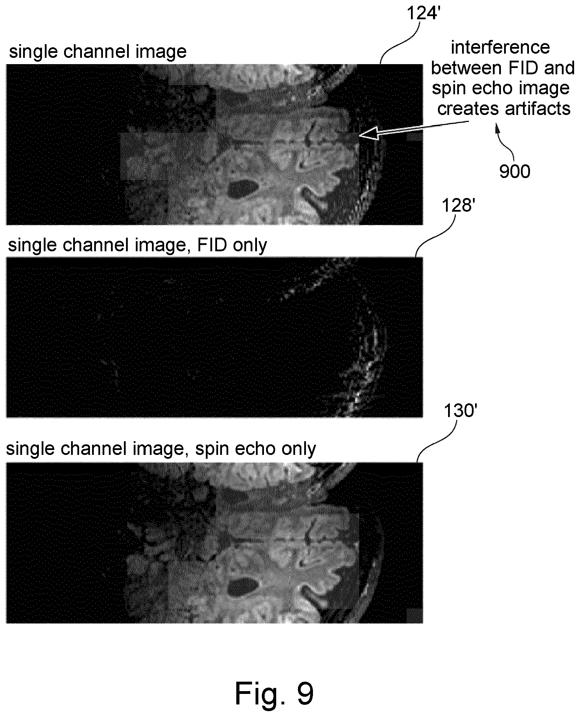

In three-dimensional TSE the FID signal is fully phase-encoded, it produces an image, which overlaps with the image of the spin echo. But because the central region of the FID k-space is missing from the data, the FID image contains mainly high spatial frequencies. Additionally, the phase of the FID image is strongly varying because of the strong shift of the k-space along the readout direction. As a result, the FID image produces interferences with the spin echo image with high spatial frequency, exemplarily shown in Fig. 9.

Fig. 9 illustrates the removal of a free induction decay artifact from a magnetic resonance image. In Fig. 9 three images 124', 128', and 130' are shown. These are shown for so-called single-channel. Often during magnetic resonance imaging, parallel imaging techniques are used where images are acquired from multiple antenna elements and then combined to form a single clinical magnetic resonance image. In this example, for illustration purposes, images from only a single channel are shown. The initial magnetic resonance image 124' for a single channel is presented at the top. There is free induction decay artifact 900, indicated with the arrow. It represents interference between the free induction decay data and the spin echo image. Image 128' is the single-channel free induction decay artifact image 128' received from the image processing neural network 126 when the single-channel initial magnetic resonance image 124' is input into it. Image 130' is the single-channel clinical magnetic resonance image 130'. Image 130' is constructed by subtracting the single-channel free induction decay artifact image 128' from the single-channel initial magnetic resonance image 124'. The fold-over artifacts visible in Fig. 9 are due to a reduced field of view (FOV) and can be removed by the conventional unfolding methods during channel combination.

There are two common methods to suppress FID artifacts:
(a) to include strong dephasing gradients between refocusing pulse and readout to increase width of the central region of the FID k-space which is missing from the data (and thereby lowering the intensity of the FID signal);
(b) to average two acquisitions with different phases of the RF pulses, in which the generated FIDs have opposite phase and thus cancel each other.

The disadvantage of technique (a) and (b) above is that they both make the magnetic resonance imaging scan longer. Examples may have the benefit of providing a means for reducing or eliminating FID artifacts without extending the scan time.

A further insight is that mathematically, the FID image can be computed from the spin-echo image by:
1. weighting in image space (scale down where FID low, where short T1 FID high);
2. truncation (of the central part) of k-space (to move the central part of k-space to the virtual center FID);
3. shift in k-space (left or right), which is equivalent of phase-ramp in image space.

As a result, the FID image can be viewed as a convolution of the spin-echo image with a locally varying convolution kernel. The local variation of the kernel is caused only by the locally varying FID signal strength.

Thus, the artifact-free image can be computed from the corrupted image by a dedicated deconvolution. Convolutional-type neural networks are therefore effective at performing a deconvolution to produce the free induction decay artifact image.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,
Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. A method of imaging at least a part of a subject (318), comprising:
receiving (200) k-space data (122) acquired according to a fast spin echo magnetic resonance imaging protocol, wherein the k-space data is descriptive of the part of the subject;
reconstructing (202) an initial magnetic resonance image (124) from the k-space data;
receiving (204) a free induction decay artifact image (128) in response to inputting the initial magnetic resonance image into an image processing neural network (126), wherein the image processing neural network is configured for filtering free induction decay artifacts from fast spin echo magnetic resonance images;
generating (206) a clinical magnetic resonance image (130), the generating comprising a combination of at least a portion of the free induction decay artifact image and the initial magnetic resonance image; and
providing (208) the clinical magnetic resonance image.

2. The method of claim 1, further comprising acquiring the k-space data by controlling (400) a magnetic resonance imaging system (302) with pulse sequence commands (330), wherein the pulse sequence commands are according to the fast spin echo magnetic resonance imaging protocol.

3. The method of claim 2, wherein the fast spin echo magnetic resonance imaging protocol is a three-dimensional turbo spin echo magnetic resonance imaging protocol.

4. The method of claim 2 or 3, wherein the pulse sequence commands are configured to cause the magnetic resonance imaging system to acquire the k-space data using refocusing pulses with flip angles less than 180 degrees, preferably less than 160 degrees.

5. The method of claim 4, wherein the flip angles are less than 140 degrees.

6. The method of any one of the preceding claims, wherein the clinical magnetic resonance image is any one of the following: a brain image, a knee image, a musculoskeletal image, a spine image, a lumbar spine image, and a brain vessel wall image.

7. The method of any one of the preceding claims, wherein the image processing neural network is any one of the following: a feed-forward convolutional neural network, a feed-forward convolutional neural with skip connections, a DnCNN, a U-Net, a ResNet, a DenseNet, and an auto-encoder neural network.

8. The method of any one of the preceding claims, wherein the convolutional neural network is trained according to the method of training a neural network according to any one of claims 9 to 12.

9. A method of training an image processing neural network, wherein the training method comprises:
receiving (600) training data (500) comprising pairs of training input images (502) and free induction decay artifact output images (504), wherein the training input images are combination of a free induction decay artifact free magnetic resonance images and the corresponding free induction decay artifact output images; and
training (602) the image processing neural network using the training data by inputting the training input images into the image processing neural network and using the corresponding free induction decay artifact output images as target images.

10. The method of training a neural network according to claim 9, wherein the training method further comprises:
receiving training data sets of data comprising a T1 map, a T2 map, and a proton density map; and
generating the pairs of training input images and the free induction decay output images synthetically using the sets of data comprising the T1 map, the T2 map, and the proton density map.

11. The method of claim 9, wherein the training method further comprises:
receiving for the training data the free induction decay artifact free magnetic resonance images;
providing image specific segmentations by segmenting the free induction decay artifact free magnetic resonance images;
assigning the image specific segmentations with T1 relaxation times, a T2 relaxation times, and proton density values;
for the free induction decay artifact free magnetic resonance images, synthetically generating the corresponding target free induction decay artifact images using the corresponding T1 relaxation times, T2 relaxation times, and proton density values for the image specific segmentations; and
providing the input training images by combining the corresponding target free induction decay artifact images to the corresponding free induction decay artifact free magnetic resonance images.

12. The method of claim 10 or 11, wherein the synthetic generation of the synthetic training input images and/or the target free induction decay images is performed using the extended phase graph method or by solution of a Bloch equation.

13. A medical system (100, 300, 500, 700) for internally imaging at least a part of a subject (318), comprising a computational system (104, 104') configured to perform a method according to any of the claims 1 to 12.

14. The medical system of claim 13, further comprising:
a magnetic resonance imaging system (302) configured for being controlled (400) by the computational system (104) to acquire the k-space data acquired according to the fast spin echo magnetic resonance imaging protocol; and
a display screen configured for being controlled by the computational system to display the clinical magnetic resonance image.

15. A computer program product comprising machine executable instructions (120, 120'), wherein execution of the machine executable instructions causes a computational system (104, 104') to perform a method according to any of the claims 1 to 12.
